# EUROPEAN PATENT APPLICATION

(11) **EP 4 769 458 A1**
(43) Date of publication of application: **01.07.2026**
(21) Application number: 25211602.5
(22) Date of filing: 28.10.2025
(51) Int. Cl.: H01F 17/00, H01F 41/04, H10W 44/00, H10W 70/65

(54) **INTEGRATED INDUCTOR WITH CONDUCTIVE POLYMER SEPARATION LAYER**

(30) Priority: 30.12.2024 US 202419005130
(71) Applicant: INTEL Corporation, Santa Clara, CA 95054 (US)
(72) Inventor: SAEEDIFARD, Farzaneh, Chandler, 85226 (US); KANDANUR, Sashi Shekhar, Phoenix, 85226 (US); LEHAF, Ali, Chandler, 85226 (US); CHO, Steve, Chandler, 85226 (US); PIETAMBARAM, Srinivas Venkata Ramanuja, Chandler, 95249 (US); ALEKSOV, Aleksandar, Chandler, 85202 (US); BRAUNISCH, Henning, Phoenix, 85018 (US); PRABHU GAUNKAR, Neelam, Chandler, 85226 (US); SERHAN, Michael, Tempe, 85281 (US)
(74) Representative: HGF

(57) **Abstract**

Examples of an integrated inductor structure including a conductive polymer separation layer as described herein. A conductive polymer layer between the seed layer and the magnetic material in an integrated inductor can act like an isolation layer between the magnetic material and seed layer to improve inductor performance (e.g., by reducing eddy current-induced inductor efficiency degradation). In one example, a microelectronic assembly includes a layer of glass with a first face and a second face, and an inductor in the layer, where the inductor includes a continuous portion of a conductive material between the first face and the second face, a magnetic material at least partially surrounding the conductive material, and a conductive polymer at least partially surrounding the magnetic material.

## Description

### Background

Electronic circuits when commonly fabricated on a wafer of semiconductor material, such as silicon, are called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system, or servers, such as mainframes.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic side, cross-sectional view of one example microelectronic assembly, according to some embodiments of the present disclosure.
FIGS. 2A-2B, 3A-3B, 4A-4B, 5A-5B, and 6A-6B illustrate different cross-sectional views of examples of integrated inductors that have a conductive polymer separation layer, according to some embodiments of the present disclosure.
FIG. 7 is a flow diagram of an example method for fabricating a microelectronic assembly including an inductor with a conductive polymer separation layer, in accordance with some embodiments.
FIGS. 8A-8G provide cross-sectional side views at various stages in the fabrication of an example microelectronic assembly according to the method of FIG. 7, in accordance with some embodiments.
FIG. 9 is a top view of a wafer and dies that may include any of the IC structures disclosed herein, in accordance with any of the embodiments disclosed herein.
FIG. 10 is a side, cross-sectional view of an IC package that may include an assembly or any of the IC structures disclosed herein, in accordance with various embodiments.
FIG. 11 is a side, cross-sectional view of an IC device assembly that may include an assembly or any of the IC structures disclosed herein, in accordance with any of the embodiments disclosed herein.
FIG. 12 is a block diagram of an example electrical device that may include an assembly or any of the IC structures disclosed herein, in accordance with any of the embodiments disclosed herein.

### Detailed Description

Disclosed herein are integrated circuit (IC) structures and assemblies including an integrated inductor with a conductive polymer separation layer. The systems, methods, and devices of this disclosure each have several innovative aspects, no single one of which is solely responsible for all desirable attributes disclosed herein. Details of one or more implementations of the subject matter described in this specification are set forth in the description below and the accompanying drawings.

Inductors play a critical role in modern microelectronic assemblies, particularly in voltage regulators. In some examples, the inductors for such circuitry may be integrated into a package substrate (e.g., the core of the package substrate).

One type of inductor that may be integrated into a package substrate is a coaxial inductor, such as a coaxial magnetic integrated inductor (coaxial MIL). Coaxial inductors may be formed in a substrate by forming an opening in the substrate (e.g., a through hole or plated through hole (PTH) in the package core), and coating the opening in a magnetic material. The trend towards using glass substrates has enabled the integration of inductors with smaller dimensions, and therefore smaller pitches than was previously achieved with conventional package substrates. The small via width that can be achieved in glass substrates further enables the use of high permeability materials in a smaller footprint to improve inductance density, as well as improved design flexibility.

According to some examples, such integrated coaxial inductors can be fabricated by depositing a magnetic material into the through holes in a glass substrate using an electrolytic plating process (also referred to as electroplating). Typically, seed layer(s) are first deposited on sidewalls of the opening to enable electrolytic plating of the magnetic material. Therefore, one or more seed layers are deposited using processes other than electrolytic plating, such as electroless plating or sputtering. Seed layers, such as copper seeds or other copper-like seeds, may be highly conductive and have a low sheet resistance (e.g., about 1 ohm per square). Electroplating the magnetic material over a seed layer with low sheet resistance can be detrimental to the operation of the inductor. For example, The seed layer(s) can negatively affect the impedance of the eddy current loop in the magnetic material and significantly reduce the efficiency of the inductor.

According to examples described herein, a conductive polymer layer between the seed layer and the magnetic material in an integrated inductor can act like an isolation layer between the magnetic material and seed layer to improve inductor performance (e.g., by reducing eddy current-induced inductor efficiency degradation). In one example, a microelectronic assembly includes a layer of glass with a first face and a second face, and an inductor in the layer, where the inductor includes a continuous portion of a conductive material between the first face and the second face, a magnetic material at least partially surrounding the conductive material, and a conductive polymer at least partially surrounding the magnetic material.

IC structures and microelectronic assemblies including an integrated inductor with a conductive polymer separation layer as described herein may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of an integrated inductor with a conductive polymer separation layer as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

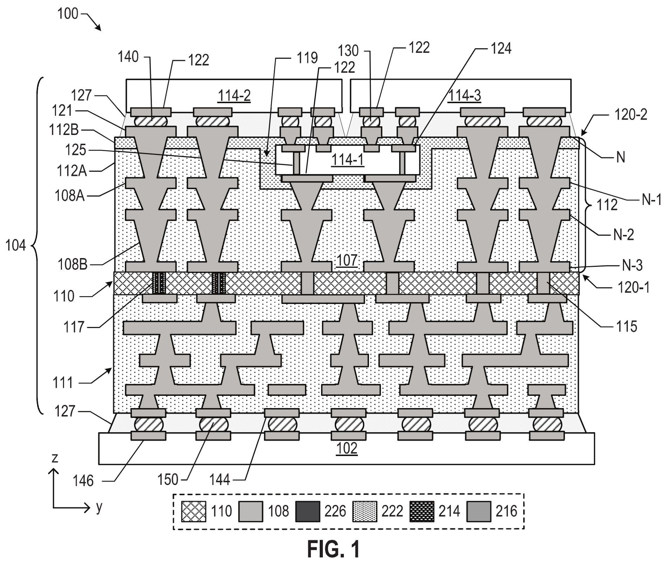

A number of elements referred to in the description of FIGS. 1, 2A-2B, 3A-3B, 4A-4B, 5A-5B, 6A-6B, and 8A-8G with reference numerals are illustrated in these drawings with different patterns, with a legend showing the correspondence between the reference numerals and patterns being provided at the bottom of each drawing page containing FIGS. 1, 2A-2B, 3A-3B, 4A-4B, 5A-5B, 6A-6B, and 8A-8G. For example, the legend illustrates that FIG. 1 uses different patterns to show a glass core 110, a conductive material 216, and so on.

FIG. 1 is a schematic side, cross-sectional view of one example microelectronic assembly 100 in which a glass core with one or more integrated inductors with conductive polymer separation layers as described herein may be implemented, according to some embodiments of the present disclosure. The microelectronic assembly 100 may include a substrate 107 with a double-sided bridge die 114-1 in a cavity 119 in the substrate 107, the die 114-1 may be electrically coupled to a conductive pathway, e.g., a conductive trace 108A or a conductive via 108B, in a metal layer of the substrate 107 that is beneath a bottom of the cavity 119. As used herein, the terms "die," "microelectronic component," and similar variations may be used interchangeably. As used herein, the terms "interconnect component," "bridge die," and similar variations may be used interchangeably. The bridge die 114-1 may be electrically coupled to dies 114-2, 114-3 by die-to-die (DTD) interconnects 130 at a second surface 120-2. In particular, conductive contacts 124 on a top face of the die 114-1 may be coupled to conductive contacts 122 on a bottom face of dies 114-2, 114-3 by conductive vias 108B through the second dielectric material layer 112B. The substrate 107 may include a dielectric material 112 (e.g., a first dielectric material layer 112A and a second dielectric material layer 112B, as shown, together referred to as "one or more layers of dielectric material 112") and a conductive material 108 arranged in the one or more layers of the dielectric material 112 to provide conductive pathways (e.g., conductive traces 108A and conductive vias 108B) through the substrate 107, as well as to provide conductive pads and contacts. The substrate 107 may include a first surface 120-1 and an opposing second surface 120-2.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The dies 114-1, 114-2, and 114-3 disclosed herein may include an insulating material (e.g., a dielectric material formed in multiple layers, as known in the art) and multiple conductive pathways formed through the insulating material. In some embodiments, the insulating material of a die (e.g., of dies 114-1, 114-2, 114-3) may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of the dies 114-1, 114-2, and 114-3 may include a semiconductor material, such as silicon, germanium, or a III-V material (e.g., gallium nitride), and one or more additional materials. For example, an insulating material may include silicon oxide or silicon nitride. The conductive pathways in the dies 114-1, 114-2, and 114-3 may include conductive traces and/or conductive vias, and may connect any of the conductive contacts in the dies 114-1, 114-2, and 114-3 in any suitable manner (e.g., connecting multiple conductive contacts on a same surface or on different surfaces of the dies 114-1, 114-2, and 114-3). Example structures that may be included in the dies 114-1, 114-2, and 114-3 disclosed herein are discussed below with reference to the IC device 1800. The conductive pathways in the dies 114-1, 114-2, 114-3 may be bordered by liner materials, such as adhesion liners and/or barrier liners, as suitable. In some embodiments, one or more of the dies 114-1, 114-2, and 114-3 are wafers. In some embodiments, one or more of the dies 114-1, 114-2, and 114-3 is a monolithic silicon, a fan-out or fan-in package die, or a die stack (e.g., wafer stacked, die stacked, or multi-layer die stacked).

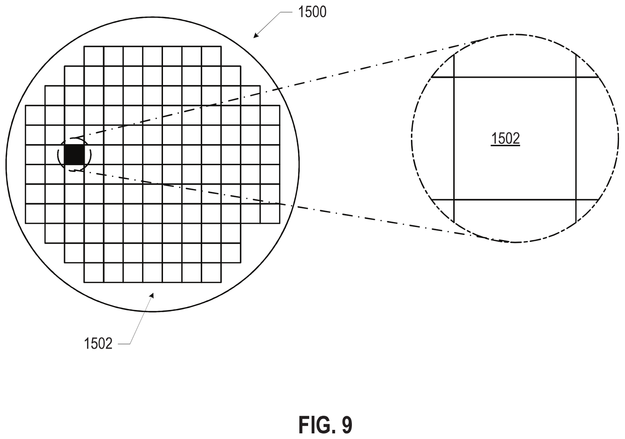

In some embodiments, the 114-1, 114-2, and 114-3 may include conductive pathways to route power, ground, and/or signals to/from other dies 114-1, 114-2, and 114-3 included in the microelectronic assembly 100. For example, the die 114-1 may include TSVs 125, including a conductive via, such as a metal via, isolated from the surrounding silicon or other semiconductor material by a barrier oxide),or other conductive pathways through which power, ground, and/or signals may be transmitted between the package substrate 102 and one or more dies "on top" of the die 114-1 (e.g., in the embodiment of FIG. 1, the dies 114-2 and/or 114-3). In some embodiments, the die 114-1 may not route power and/or ground to the dies 114-2 and 114-3; instead, the dies 114-2, 114-3 may couple directly to power and/or ground lines in the package substrate 102 by substrate-to-package substrate (STPS) interconnects 150, conductive pathways provided by the conductive material 108 in the substrate 107, and die-to-substrate (DTS) interconnects 140. In some embodiments, the die 114-1 may be thicker than the dies 114-2, 114-3. In some embodiments, the die 114-1 may be a memory device or a high frequency serializer and deserializer (SerDes), such as a Peripheral Component Interconnect (PCI) express. In some embodiments, the die 114-1 may be a processing die, a radio frequency chip, a power converter, a network processor, a workload accelerator, a voltage regulator die, or a security encryptor. In some embodiments, the die 114-2 and/or the die 114-3 may be a processing die, a radio frequency chip, a power converter, a network processor, a workload accelerator, a voltage regulator die, or a security encryptor. In some embodiments, the dies 114-1, 114-2, and 114-3 may be as described below with reference to the die 1502 of FIG. 9.

The dielectric material 112 of the substrate 107 may be formed in layers (e.g., at least a first dielectric material layer 112A and a second dielectric material layer 112B). In some embodiments, the dielectric material 112 may include an organic material, such as an organic buildup film. In some embodiments, the dielectric material 112 may include a ceramic, an epoxy film having filler particles therein, glass, an inorganic material, or combinations of organic and inorganic materials, for example. In some embodiments, the conductive material 108 may include a metal (e.g., copper). In some embodiments, the substrate 107 may include layers of dielectric material 112/conductive material 108, with lines/traces/pads/contacts (e.g., conductive traces 108A) of conductive material 108 in one layer electrically coupled to lines/traces/pads/contacts (e.g., conductive traces 108A) of conductive material 108 in an adjacent layer by vias (e.g., 108B) of the conductive material 108 extending through the dielectric material 112. Conductive traces 108A may be referred to herein as "conductive lines," "conductive elements," "conductive pads," or "conductive contacts." A substrate 107 including such layers may be formed using a printed circuit board (PCB) fabrication technique, for example.

A substrate 107 may include N layers of conductive material 108, where N is an integer greater than or equal to one. In FIG. 1, the layers are labeled in descending order from the second surface 120-2 (e.g., the top face) of the substrate 107 (e.g., layer N, layer N-1, layer N-2, etc.). In particular, as shown in FIG. 1, a substrate 107 may include four metal layers (e.g., N, N-1, N-2, and N-3). The N metal layer may include conductive contacts 121 at the second surface 120-2 of the substrate 107 that are coupled to conductive contacts 122 at bottom faces of the die 114-2, 114-3 by DTS interconnects 140. The N-2 metal layer may include conductive traces 108A having a top face (e.g., the surface facing towards the second surface 120-2 of the substrate 107), an opposing bottom face (e.g., the surface facing towards the first surface 120-1 of the substrate 107), and lateral surfaces extending between the top and bottom faces of the conductive traces 108A. A substrate 107 may further include an N-1 metal layer above the N-2 metal layer and below the N metal layer.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

As shown in FIG. 1, the substrate 107 may further include a glass core 110. The glass core 110 may also be referred to as a layer of glass or a glass substrate. Further layers 111 may be present below the glass core 110 and coupled to a package substrate 102 by interconnects 150. As used herein, the term "glass core" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass core 110 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass core 110 may be an amorphous solid glass layer. In some embodiments, the glass core 110 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass core 110 may include a material, e.g., any of the materials described above, with a weight percentage of silicon being at least about 0.5%, e.g., between about 0.5% and 50%, between about 1% and 48%, or at least about 23%. For example, if the glass core 110 is fused silica, the weight percentage of silicon may be about 47%. In some embodiments, the glass core 110 may include a material having at least 23% silicon and/or at least 26% oxygen by weight, and, in some further embodiments, the glass core 110 may further include at least 5% aluminum by weight. In some embodiments, the glass core 110 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass core 110 may be a layer of glass that does not include an organic adhesive or an organic material. The glass core 110 may be distinguished from, for example, the "prepreg" or "FR4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contrast, the glass core 110 may be a layer of glass that is about 10 millimeters on a side to about 250 millimeters on a side (e.g., 10 millimeters x 10 millimeters to 250 millimeters x 250 millimeters).

In some embodiments, a cross-section of the glass core 110 in an x-z plane, a y-z plane, and/or an x-y plane of an example coordinate system shown in FIG. 1, may be substantially rectangular (axes shown in subsequent drawings refer to the axes of the coordinate system shown in FIG. 1), although in some further embodiments the glass core 110 may have rounded or beveled edges/sides/sidewalls. In some embodiments, in the top-down view of the glass core 110 (e.g., the x-y plane of the coordinate system shown in FIG. 1), the glass core 110 may have a first length in a range of 10 millimeters to 250 millimeters, and a second length in a range of 10 millimeters to 250 millimeters, the first length perpendicular to the second length. A thickness of the glass core 110 (e.g., a dimension measured along the z-axis of the coordinate system of FIG. 1) may be in a range of about 50 micron to 1.4 millimeters. In some embodiments, the glass core 110 may be a glass core substrate, where the glass core substrate has a thickness in a range of about 50 microns to 1.4 millimeters. In some embodiments, the glass core 110 may be a layer of glass comprising a rectangular prism volume, possibly with rounded or beveled edges/sides/sidewalls. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass core 110 may be a rectangular prism volume with sections (e.g., vias) removed and filled with other materials (e.g., metal) e.g., the TGVs 115. In some embodiments, the glass core 110 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

In some implementations, together, the substrate 107, including the glass core 110, and the dies 114-1, 114-2, 114-3 may be referred to as a "a multi-layer die subassembly 104." The glass core 110 may provide mechanical stability to the multi-layer die subassembly 104, the substrate 107, and/or the microelectronic assembly 100. The glass core 110 may reduce warpage and may provide a more robust surface for attachment of the multi-layer die subassembly 104 to a package substrate 102 or other substrate (e.g., an interposer or a circuit board).

In some implementations, together, the dielectric material 112 of the substrate 107 and the glass core 110 may be referred to as a "multi-layer glass substrate." In some such embodiments, the glass core 110 may be a glass layer having a thickness in a range of about 25 microns to 50 microns. In some embodiments, the further layers 111 may also be part of the multi-layer glass substrate. In some such embodiments, the substrate may be a coreless substrate.

In the example in FIG. 1, the glass core 110 includes through glass vias (TGVs) 115 and 117. In the illustrated example, some of the TGVs may be or include conductive vias that include a conductive material to form conductive interconnects, and some of the TGVs may include inductor structures. For example, the TGVs 115 are conductive vias that may include any appropriate conductive material, e.g., a metal such as copper, silver, nickel, gold, aluminum, or other metals or alloys. The TGVs 117 are or include integrated inductors that have a conductive polymer separation layer in accordance with examples described herein. The TGVs 115 and 117 may be vias extending between a first side and a second side of the glass core 110 (e.g., between the bottom face and the top face of the glass core 110). Thus, in some examples, an assembly may include both conductive vias and vias including inductor structures in the same plane or layer, both of which may extend through the glass core 110 between a first face and a second face of the glass core 110. The openings for the TGVs 115 and 117 may be formed using any suitable process, including, for example, a direct laser drilling or laser-induced etching process (which may also be referred to as laser patterning or selective laser activation). In some embodiments, the TGVs 115 and 117 disclosed herein may have a pitch between 50 microns and 500 microns, e.g., as measured from a center of one TGV 115, 117 to a center of an adjacent TGV 115, 117. The TGVs 115 and 117 may have any suitable size and shape. In some embodiments, the TGVs 115 and 117 may have a round (e.g., circular or oval), rectangular, or other shaped cross-section. In some embodiments, at least some of the TGVs 115 and 117 may have an hourglass shape (e.g., the TGVs 115 and 117 may taper from both sides so that the TGVs have a narrower width between two larger widths). In some embodiments, at least some of the TGVs 115 and 117 may taper down from one face of the glass core 110 to another, e.g., from the top face of the glass core 110 to the bottom face of the glass core 110.

The substrate 107 (e.g., further layers 111) may be coupled to a package substrate 102 by STPS interconnects 150. In particular, the top face of the package substrate 102 may include a set of conductive contacts 146. Conductive contacts 144 on the bottom face of the substrate 107 may be electrically and mechanically coupled to the conductive contacts 146 on the top face of the package substrate 102 by the STPS interconnects 150. The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), bismaleimide triazine (BT) resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard PCB processes, the package substrate 102 may include FR-4, and the conductive pathways in the package substrate 102 may be formed by patterned sheets of copper separated by buildup layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the dies 114-1, 114-2, 114-3 may be a higher density medium or have an area with a higher density medium. As used herein, the terms "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive buildup process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual-damascene process. In some embodiments, additional dies may be disposed on the top face of the dies 114-2, 114-3. In some embodiments, additional components may be disposed on the top face of the dies 114-2, 114-3. Additional passive components, such as surface-mount resistors, capacitors, and/or inductors, may be disposed on the top face or the bottom face of the package substrate 102, or embedded in the package substrate 102.

The microelectronic assembly 100 of FIG. 1 may also include an underfill material 127. In some embodiments, the underfill material 127 may extend between the substrate 107 and the package substrate 102 around the associated STPS interconnects 150. In some embodiments, the underfill material 127 may extend between different ones of the top level dies 114-2, 114-3 and the top face of the substrate 107 around the associated DTS interconnects 140 and between the bridge die 114-1 and the top level dies 114-2, 114-3 around the DTD interconnects 130. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering the multi-layer die subassembly 104 to the package substrate 102 when forming the STPS interconnects 150, and then polymerizes and encapsulates the STPS interconnects 150. The underfill material 127 may be selected to have a CTE that may mitigate or minimize the stress between the substrate 107 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114-1, 114-2, 114-3 and/or dielectric material 112 of the substrate 107.

The STPS interconnects 150 disclosed herein may take any suitable form. In some embodiments, a set of STPS interconnects 150 may include solder (e.g., solder bumps or balls that are subject to a thermal reflow to form the STPS interconnects 150), for example, as shown in FIG. 1, the STPS interconnects 150 may include solder between a conductive contacts 144 on a bottom face of the substrate 107 and a conductive contact 146 on a top face of the package substrate 102. In some embodiments, a set of STPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the STPS interconnects 150 in a microelectronic assembly. In some embodiments, the dies 114-1, 114-2, 114-3 on either side of a set of DTD interconnects 130 may be unpackaged dies, and/or the DTD interconnects 130 may include small conductive bumps (e.g., copper bumps). The DTD interconnects 130 may have too fine a pitch to couple to the package substrate 102 directly (e.g., too fine to serve as DTS interconnects 140 or STPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the STPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the DTD interconnect 130 may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, some or all of the DTD interconnects 130 and/or the DTS interconnects 140 in a microelectronic assembly 100 may be solder interconnects that include a solder with a higher melting point than a solder included in some or all of the STPS interconnects 150. For example, when the DTD interconnects 130 and the DTS interconnects 140 in a microelectronic assembly 100 are formed before the STPS interconnects 150 are formed, solder-based DTD interconnects 130 and DTS interconnects 140 may use a higher-temperature solder (e.g., with a melting point above 200 degrees Celsius), while the STPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTS interconnects 140 and the STPS interconnects 150 may have a larger pitch than some or all of the DTD interconnects 130. DTD interconnects 130 may have a smaller pitch than STPS interconnects 150 due to the greater similarity of materials in the different dies 114-1, 114-2, 114-3 on either side of a set of DTD interconnects 130 than between the substrate 107 and the top level dies 114-2, 114-3 on either side of a set of DTS interconnects 140, and between the substrate 107 and the package substrate 102 on either side of a set of STPS interconnects 150. In particular, the differences in the material composition of a substrate 107 and a die (e.g., one or more of the dies 114-1, 114-2, 114-3) or a package substrate 102 may result in differential expansion and contraction due to heat generated during operation (as well as the heat applied during various manufacturing operations). To mitigate damage caused by this differential expansion and contraction (e.g., cracking, solder bridging, etc.), the DTS interconnects 140 and the STPS interconnects 150 may be formed larger and farther apart than DTD interconnects 130, which may experience less thermal stress due to the greater material similarity of the pair of dies on either side of the DTD interconnects. In some embodiments, the DTS interconnects 140 disclosed herein may have a pitch between 25 microns and 250 microns. In some embodiments, the STPS interconnects 150 disclosed herein may have a pitch between 55 microns and 1000 microns, while the DTD interconnects 130 disclosed herein may have a pitch between 25 microns and 100 microns.

The microelectronic assembly 100 of FIG. 1 may also include a circuit board (not shown). The package substrate 102 may be coupled to the circuit board by second-level interconnects at the bottom face of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board, but may instead couple the package substrate 102 to another IC package, an interposer, or any other suitable component. In some embodiments, the substrate 107 may not be coupled to a package substrate 102, but may instead be coupled to a circuit board, such as a PCB.

Although FIG. 1 depicts a microelectronic assembly 100 having a substrate with a particular number of dies and conductive pathways provided by the conductive material 108 coupled to other dies, this number and arrangement are simply illustrative, and a microelectronic assembly 100 may include any desired number and arrangement of dies. Although FIG. 1 shows the die 114-1 as a double-sided die and the dies 114-2, 114-3 as single-sided dies, the dies 114-2, 114-3 may be double-sided dies and the die 114-1 may be a single-pitch die or a mixed-pitch die. In some embodiments, additional components may be disposed on the top face of the dies 114-2 and/or 114-3. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Further, various elements are illustrated in FIG. 1 as included in the microelectronic assembly 100, but, in various embodiments, some of these elements may not be included. For example, in various embodiments, the further layers 111, the underfill material 127, and the package substrate 102 may not be present in the microelectronic assembly 100. In some embodiments, individual ones of the microelectronic assemblies 100 disclosed herein may serve as a system-in-package (SiP) in which multiple dies 114-1, 114-2, 114-3 having different functionality are included. In such embodiments, the microelectronic assembly 100 may be referred to as an SiP.

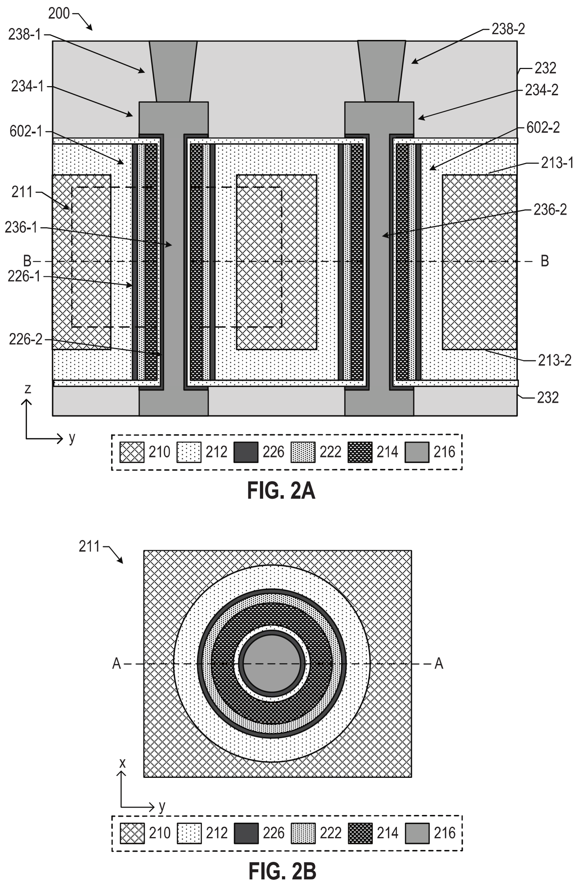

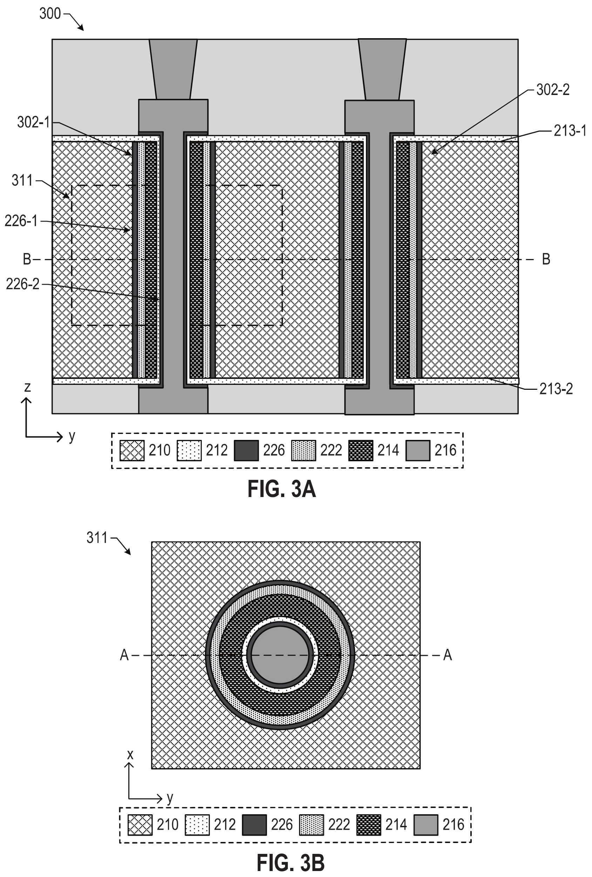

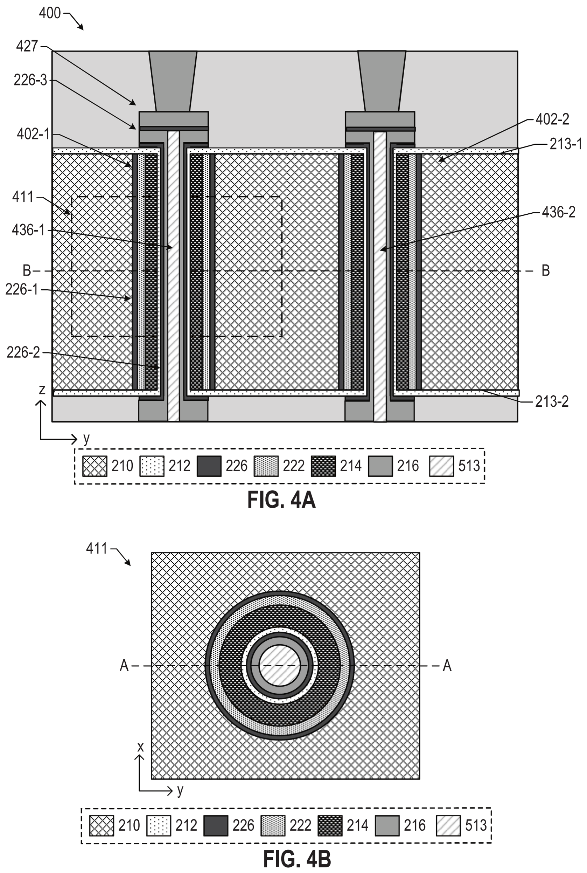

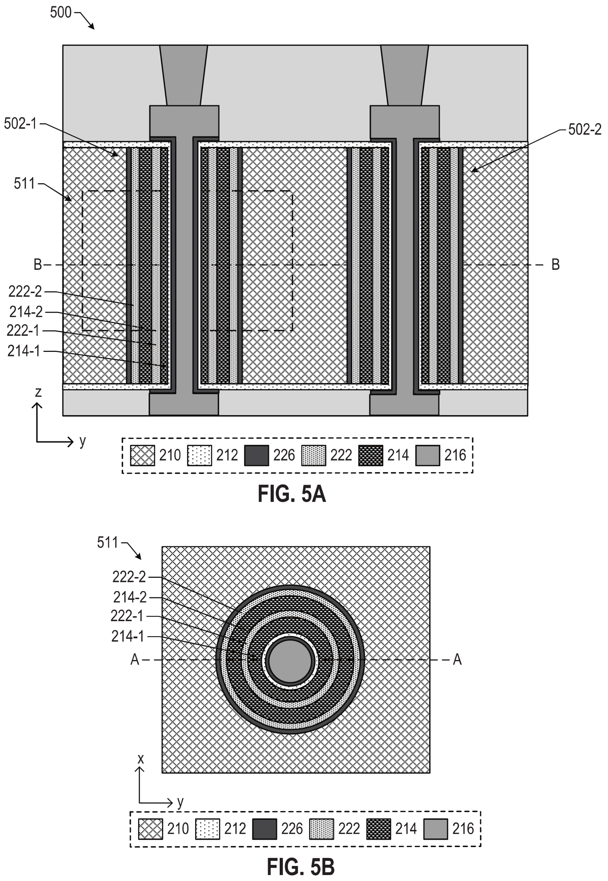

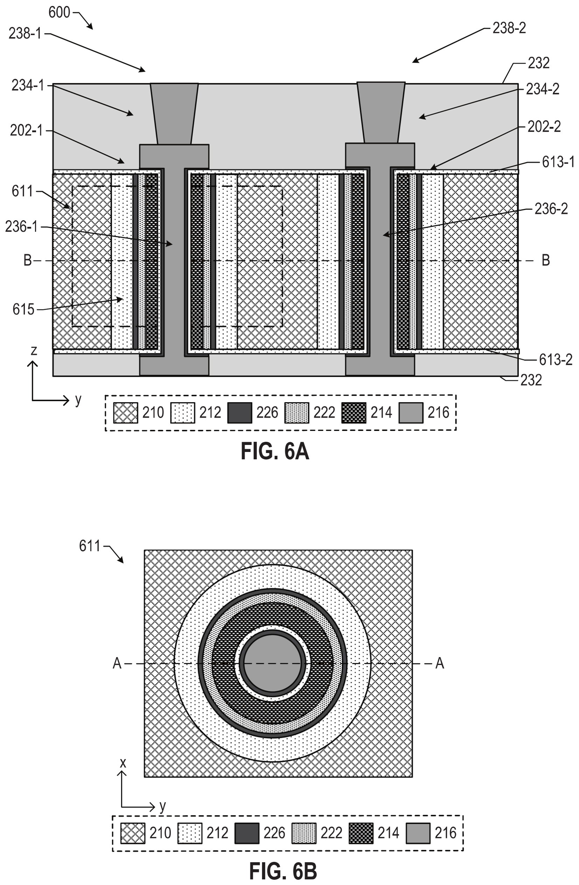

FIGS. 2A-2B, 3A-3B, 4A-4B, 5A-5B, and 6A-6B illustrate different cross-sectional views of examples of integrated inductors that have a conductive polymer separation layer. The inductors shown in FIGS. 2A-2B, 3A-3B, 4A-4B, 5A-5B, and 6A-6B are examples of coaxial inductors that are integrated into a glass or other substrate. The inductors described herein may thus be referred to as inductor structures, integrated inductors, coaxial inductors, or coaxial magnetic integrated inductors. Those figures of FIGS. 2A-2B, 3A-3B, 4A-4B, 5A-5B, and 6A-6B that are labeled with a letter A (e.g., FIG. 2A) illustrate cross-sections in the y-z plane of the example coordinate system shown in FIG. 1 along a plane AA shown in a corresponding figure labeled with a letter B (e.g., along a plane AA shown in FIG. 2B). Those figures of FIGS. 2A-2B, 3A-3B, 4A-4B, 5A-5B, and 6A-6B that are labeled with a letter B (e.g., FIG. 2B) illustrate cross-sections in the x-y plane of the example coordinate system shown in FIG. 1 along a plane BB shown in a corresponding figure labeled with a letter A (e.g., along a plane BB shown in FIG. 2A). A dashed line box in the corresponding figure labeled with a letter A illustrates a region of the IC structure shown in the figure labeled with a letter B. For example, a dashed line box in FIG. 2A indicates a region 211 shown in the cross-section of FIG. 2B. A dashed line box in FIG. 3A indicates a region 311 shown in the cross-section of FIG. 3B. A dashed line box in FIG. 4A indicates a region 411 shown in the cross-section of FIG. 4B. A dashed line box in FIG. 5A indicates a region 511 shown in the cross-section of FIG. 5B. Similarly, a dashed line box in FIG. 6A indicates a region 611 shown in the cross-section of FIG. 6B.

Turning first to FIGS. 2A-2B, the IC structure 200 includes a layer of glass 210 including a first side or face 213-1 and a second side or face 213-2. The layer of glass 210 may be, for example, a glass core. The other examples, a different core material may be present in the assembly (e.g., ceramic, epoxy, or another core material). The IC structure 200 includes two inductors 202-1 and 202-2 in the layer of glass 210. As can be seen in FIGS. 2A and 2B, the inductors 202-1, 202-2 extend through the layer of glass 210 such that portions of the inductors 202-1, 202-2 are coplanar with the first face 213-1 and the second face 213-2 opposite the first face 213-1 of the layer of glass 210. In the example illustrated in FIGS. 2A-2B, an insulator material 212 is present between the glass 210 and the inductors 202-1, 202-2 (e.g., between the glass two and sidewalls of the inductors 202-1, 202-2), and also on the first face 213-1 and on the second face 213-2. In one such example, the insulator material 212 may include a non-conductive polymer or other suitable insulator material. In the example illustrated in FIGS. 2A-2B, an insulator material 232 is present in layers above and below the layer of glass 210, where the insulator material 232 has a different material composition than the core material (e.g., different from the layer of glass 210). The insulator material 232 may be or include a buildup material (also known as buildup layer(s)), an interlayer dielectric (ILD) material, or any other suitable insulator material. In some examples, the insulator material 232 may include an organic dielectric material (e.g., a polyimide or other suitable dielectric material) and/or a buildup film.

The inductors 202-1, 202-2 include a conductive material 216, which may fill the interior regions (e.g., regions 236-1 and 236-2, respectively) of the inductors 202-1, 202-2, such as illustrated in FIGS. 2A-2B. The portion of the conductive material 216 filling the inductors 202-1, 202-2 may therefore be referred to as a conductive plug. In other examples, as discussed below, the interior of an inductor may include a void or another material, such as a dielectric material. As can be seen in FIGS. 2A-2B, a continuous portion of the conductive material 216 is between the first face 213-1 and the second face 213-2. In one example, the conductive material 216 may be any suitable electrically conductive material, such as a material including a metal. In one example, the conductive material 216 may be or include copper.

In the example illustrated in FIGS. 2A-2B, a portion of the conductive material 216 may form a conductive contact structure coupled with each of the inductors 202-1 and 202-2. For example, a conductive contact structure 234-1 may include a portion of conductive material 216 that is over and coupled with (e.g., in contact with, e.g., in direct contact with) the conductive material 216 in the interior region 236-1 of the inductor 202-1. Similarly, a conductive contact structure 234-2 may include a portion of conductive material 216 that is over and coupled with the conductive material 216 in the interior region 236-2 of the inductor 202-2. In some examples, the conductive material 216 of the conductive contact structures 234-1 and 234-2 may be the same as, or different from, the conductive material 216 in the interior regions 236-1, 236-2 of the inductors 202-1, 202-2. In some examples, the conductive material 216 in the interior regions 236-1, 236-2 of the inductors 202-1, 202-2 and the conductive material 216 of the contact structures 234-1, 234-1 may be deposited in the same process, or with different processes. Conductive interconnects 238-1, 238-2 extend through the insulator material 232 over the inductors 202-1, 202-2 to couple with respective conductive contact structures 234-1, 234-2.

The inductor further includes a magnetic material 214 at least partially surrounding the conductive material 216. As can be seen in FIG. 2B, the magnetic material 214 of the inductor 202-1 completely surrounds the continuous portion of the conductive material 216 that is present in the middle or central region of the inductor 202-1 between the first face 213-1 and the second face 213-2. The magnetic material 214 may include a ferromagnetic element. The magnetic material 214 may include, for example, cobalt nickel iron, cobalt iron, or another ferromagnetic material (e.g., a ferromagnetic rare earth metal). In some examples, the magnetic material 214 may be substantially pure, e.g., the magnetic regions may include at least 80%, at least 90%, at least 95%, or at least 99% of a ferroelectric element by weight or cross-sectional area. In some embodiments, the magnetic material 214 includes a mix of multiple ferroelectric elements, where the ferroelectric elements combined make up at least 80%, at least 90%, etc. of the magnetic regions by weight or cross-sectional area. In some examples, the magnetic material 214 may include dopants, such as one or more of boron, sulfur, phosphorus, and oxygen. In some examples, the magnetic material 214 is deposited with an electroplating process.

The inductors 202-1, 202-2 also include an insulator material 212 between the magnetic material 214 and the conductive material 216. Although the insulator material 212 between the magnetic material 214 and the conductive material 216 is shown in FIGS. 2A-2B as being the same material as the insulator material 212 between the glass 210 and the inductors 202-1, 202-2, the insulator material 212 between the magnetic material 214 and the conductive material 216 may be substantially the same or different from the insulator material between the glass 210 and the inductors 202-1, 202-2. In the example illustrated in FIGS. 2A-2B, the inductors 202-1, 202-2 also include a seed layer 226-2 of a seed material 226 between the conductive material 216 and the insulator material 212 that is on the magnetic material 214 (e.g., to enable the deposition of the conductive material 216 with an electrolytic plating process). In one example, the seed layer 226-2 includes a metal such as copper or another suitable seed material (e.g., a copper-like seed material) that enables deposition of the conductive material 216 onto the seed layer 226-2 (e.g., with an electrolytic plating process).

The inductors 202-1 and 202-2 also include a conductive polymer 222 (e.g., a conductive polymer separation layer) at least partially surrounding the magnetic material 214. Thus, instead of electroplating the magnetic material 214 directly onto a seed layer 226-1 on sidewalls of the opening, a layer of a conductive polymer 222 is deposited on (e.g., directly on) the seed layer 226-1, and the magnetic material 214 may then be electroplated onto the conductive polymer 222 on the sidewalls of the opening. In some examples, the seed layer 226-1 on the sidewalls of the opening in the glass 210 (e.g., on the glass 210 or on the insulator material 212 on the glass 210) may have the same or a different material composition relative to the seed layer 226-2 between the magnetic material 214 and the conductive material 216. In some examples, the conductive polymer includes one or more of polythiophene and polypyrrole, or another suitable conductive polymer. Conducting or conductive polymers, also known as 'conjugated polymers,' are multi-molecular compounds having a system of conjugated bonds in the main chain. According to examples, the conduction of electrons takes place along the main polymer chain and is possible due to the presence of conjugated bonds. In one such example, the mechanism of conductivity is related to the presence of an energetic conduction band resulting from electron delocalization in double bonds. Electrons can be released from one of the conjugated double bonds present in the chain. Polythiophene and polypyrrole belong to the group of electrically conductive polymers. The conductivity of such polymers may be increased with dopants, such as molecular organic dopants and inorganic dopants. In some examples, the conductive polymer 222 may include (e.g., be doped with) an alkali metal or DMBI-H. In some examples, the conductive polymer has a thickness on the sidewalls of the opening in a range of about 1 to 10 microns, where the thickness is a dimension of the conductive polymer 222 in a plane substantially parallel with the layer of glass 210 (e.g., with a glass substrate).

According to examples, the conductive polymer 222 could be electroplated on the seed layer 226-1 (e.g., the seed layer 226-1 on the sidewalls onto the glass 210 or onto the insulator material 212 on the glass 210) and act as an intralayer isolation material. In one such example, the conductive polymer 222 is sufficiently conductive so that the magnetic material 214 can be plated on top of the conductive polymer 222 on the sidewalls. In one example, the conductive polymer 222 may have a conductivity in the range of about 100 S/m to 1000 S/m, or in the range of about 500 S/m to 1000 S/m. The conductive polymer 222 may also have a relatively high thermal stability (e.g., higher than about 250 °C), making the conductive polymer 222 a suitable material for use in the inductors 202-1, and 202-2, which may be formed in processed panels that endure thermal stress from subsequent processing. Thus, the IC structure 200 of FIGS. 2A-2B includes inductors 202-1, 202-2 with a layer of a conductive polymer between the glass 210 and the magnetic material 214.

FIGS. 3A-3B illustrate different cross-sectional views of another example of an IC structure 300 with integrated inductors 302-1, 302-2 that have a conductive polymer separation layer. As can be seen in FIGS. 3A-3B, the inductors 302-1 and 302-2 are substantially the same as the inductors 202-1, 202-2. However, the IC structure 300 of FIGS. 3A-3B lacks an insulator/buffer material on the faces 213-1 and 213-2 of the glass 210 and between the glass 210 and the seed layer 226 on sidewalls of the openings through the glass 210. Therefore, in the example illustrated in FIGS. 3A-3B, the seed layer 226 is on and in direct contact with the glass 210, whereas in the example illustrated in FIGS. 2A-2B, an insulator material 212 is present on sidewalls of the openings in the glass 210 and the seed layer is on the insulator material 212. Additionally, in FIG. 3A, the layer of insulator material 212 is on the face 213-1 and 213-2 of the glass 210 in addition to being between the magnetic material and seed layer 226-2.

FIGS. 4A-4B illustrate different cross-sectional views of another example of an IC structure 400 with integrated inductors 402-1, 402-2 that have a conductive polymer separation layer. The inductors 402-1 and 402-2 are similar to the inductors 302-1 and 302-2 of FIGS. 3A-3B, discussed above, in that the inductors 402-1 and 402-2 include a conductive material 216 in a via opening, a seed layer 226-1 on sidewalls of the via between the glass 210 and the conductive material 216, a conductive polymer 222 on the sidewalls between the seed layer 226-1 and the conductive material 216, a magnetic material 214 on the sidewalls between the conductive polymer 222 and the conductive material 216, and an insulator material 212 between the magnetic material 214 and the conductive material 216. However, the inductors 402-1 and 402-2 differ from the inductors 202-1 and 202-2 in that the inductors 402-1 and 402-2 include a dielectric material 513 (e.g., dielectric plugs) in the central regions 436-1 and 436-2 of the inductors 402-1 and 402-2. Therefore, as can be seen in FIGS. 4A-4B, the inductors 402-1, 402-2 each include a continuous portion of the insulator material 513 between the faces 213-1 and 213-2 of the layer of glass 210, and the conductive material 216 surrounds an insulator material 513. In the example illustrated in FIG. 4A, the dielectric plug is taller than the thickness of the glass 210, so that the continuous portion of insulator material 513 extends beyond the face 213-1 and beyond the face 213-2 (where the height of the dielectric plug and the thickness of the glass are dimensions of those structures in a plane substantially orthogonal to the layer of glass 210, e.g., along the z-axis as shown in FIG. 4A). Thus, in the example illustrated in FIG. 4A, a portion 513-2 of the insulator material 513 is coplanar with a portion of the conductive material 216 that is over the glass 210 (e.g., a portion of the conductive material 216 extending beyond the face 213-1) and a portion 513-1 of the insulator material 513 is coplanar with a portion of the conductive material 216 that is below the glass 210 (e.g., a portion of the conductive material 216 extending beyond the face 213-2). In one such example, the insulator material 513 may include a polymer material (e.g., a polymeric plug including a non-conductive polymer material) or any other suitable insulator material. The example IC structure 400 illustrated in FIG. 4A includes another seed layer 226-3 over the insulator material 513 (e.g., to enable deposition of the conductive material 216 over the insulator material 513 to form the conductive contact 427). In one such example, the seed layer 226-3 is provided over the dielectric plug, and therefore a portion of the dielectric plug (e.g., the top portion 513-2 of the insulator material 513 shown in FIG. 4A) is in contact with the seed layer 226-3. A similar structure including a seed layer and pad may be present at both sides of the IC structure 400. For example, a seed layer similar to the seed layer 226-3 may be deposited on the bottom portion 513-1 of the insulator material 513, and a conductive contact similar to the conductive contact 427 may be provided over the seed layer.

FIGS. 5A-5B illustrate different cross-sectional views of another example of an IC structure 500 with integrated inductors 502-1, 502-2 that have a conductive polymer separation layer. The inductors 502-1 and 502-2 are similar to the inductors 302-1 and 302-2 of FIGS. 3A-3B, discussed above, in that the inductors 502-1 and 502-2 include a layer of the conductive polymer 222 and a layer of the magnetic material 214 on the conductive polymer 222. However, the inductors 502-1 and 502-2 of FIGS. 5A-5B include multiple layers of alternating conductive polymer 222 and magnetic material 214. As can be seen in FIGS. 5A-5B, the inductor 502-1 includes a first magnetic layer 214-1, a first conductive polymer layer 222-1 at least partially surrounding the first magnetic layer 214-1, a second magnetic layer 214-2 at least partially surrounding the first conductive polymer layer 222-1, and a second conductive polymer layer 222-2 at least partially surrounding the second magnetic layer 214-2. The thickness on the sidewalls (e.g., width) of the layers of the conductive polymer 222 and the magnetic material 214 may be about the same or different in successive layers. For example, the width of the first conductive polymer layer 222-1 may be about the same or different from the width of the second conductive polymer layer 222-2. Similarly, the width of the first magnetic layer 214-1 may be about the same as or different from the width of the second magnetic layer 214-2. Thus, in the example illustrated in FIGS. 5A-5B, the inductor 502-1 includes multiple layers of the magnetic material 214 and the conductive polymer 222 on the sidewalls of the opening through the glass 210. In one such example, better isolation and better inductor efficiency may be achieved with such sequential deposition of the conductive polymer and the magnetic material.

FIGS. 6A-6B illustrate different cross-sectional views of another example of an IC structure 600 with integrated inductors 602-1, 602-2 that have a conductive polymer separation layer. The inductors 602-1 and 602-2 are similar to the inductors 202-1 and 202-2 of FIGS. 2A-2B, discussed above, in that the inductors 602-1 and 602-2 include a layer of the conductive polymer 222 and a layer of the magnetic material 214 on the conductive polymer 222. However, the IC structure 600 differs from the IC structure 200 in that the buffer layer (e.g., a thicker layer 615 of the insulator material 212, such as shown on sidewalls of the inductor opening in FIG. 6A) is absent from the faces 613-1 and 613-2 of the glass 210. In one such example, the buffer material may be polished off the top and bottom faces of the glass 210 prior to the deposition of a thin layer of insulator material 212 that is deposited over the magnetic material 214. As mentioned above the insulator material deposited over the magnetic material 214 may have the same or a different material composition from the buffer material (e.g., the layer 615 of insulator material).

Accordingly, FIGS. 2A-2B, 3A-3B, 4A-4B, 5A-5B, and 6A-6B illustrate different cross-sectional views of examples of integrated inductors that have a conductive polymer separation layer. Integrated inductors with one or more conductive polymer separation layers may include additional or different features than specifically shown in the examples illustrated in FIGS. 2A-2B, 3A-3B, 4A-4B, 5A-5B, and 6A-6B. For example, although the inductors in FIGS. 2A-2B, 3A-3B, 4A-4B, 5A-5B, and 6A-6B are shown as having a substantially circular cross-sectional shape, inductors may have other cross-sectional shapes (e.g., oval, rectangular, or other round or non-round cross-sectional shapes). Also, the layers of materials shown in FIGS. 2A-2B, 3A-3B, 4A-4B, 5A-5B, and 6A-6B may have different relative thicknesses than depicted in FIGS. 2A-2B, 3A-3B, 4A-4B, 5A-5B, and 6A-6B. For example, the magnetic material 214 is shown in FIGS. 2A-2B as being thicker than the conductive polymer 222; in other examples, the magnetic material 214 and the conductive polymer 222 may have substantially the same thickness, or the conductive polymer 222 may be thicker than the magnetic material 214. Other examples may have additional or different intervening layers than shown in FIGS. 2A-2B, 3A-3B, 4A-4B, 5A-5B, and 6A-6B. Additionally, although the integrated inductors of FIGS. 2A-2B, 3A-3B, 4A-4B, 5A-5B, and 6A-6B are shown as being disposed in openings in a layer of glass, in other examples, an integrated inductor with a conductive polymer separation layer may be formed in a layer, substrate, or core including a different material than glass.

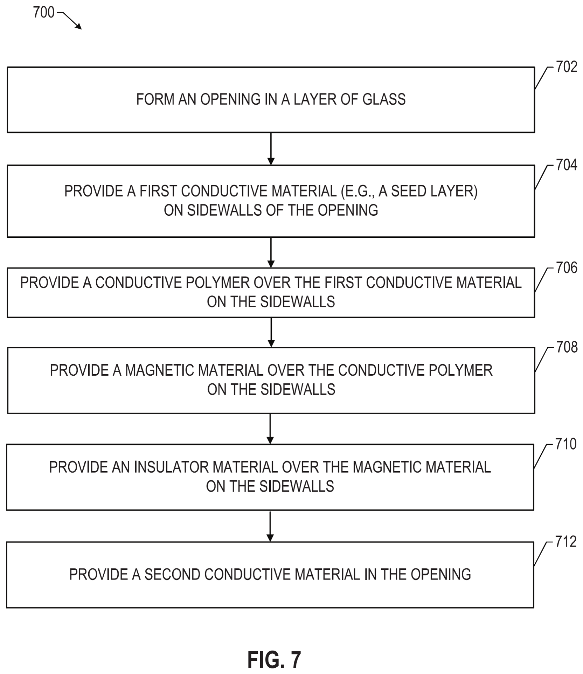

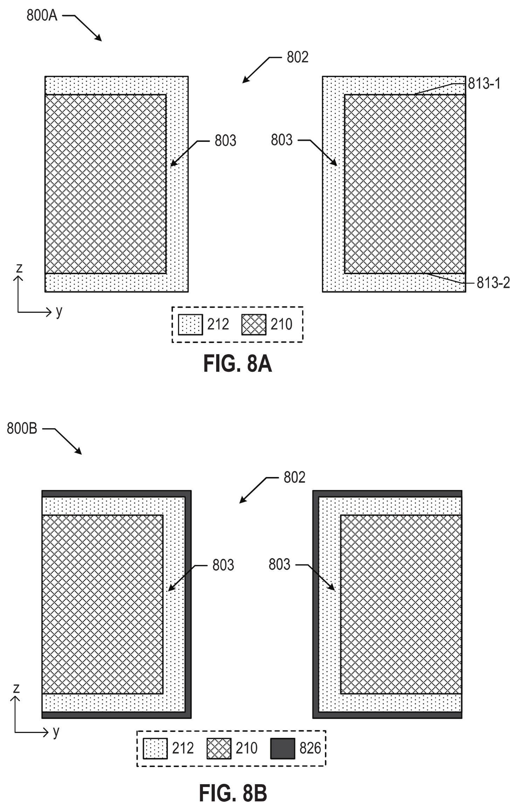

FIG. 7 is a flow diagram of an example method 700 for fabricating an IC structure or microelectronic assembly including an integrated inductor with a conductive polymer separation layer. FIGS. 8A-8G provide cross-sectional views along the y-z axis (e.g., the y-z axis as shown in FIGS. 1, 2A-2B, 3A-3B, 4A-4B, 5A-5B, and 6A-6B) at various stages in the fabrication of an example microelectronic assembly according to the method of FIG. 7, in accordance with some embodiments. Although the operations of the method of FIG. 7 are illustrated once each and in a particular order, the operations may be performed in any suitable order and repeated as desired. For example, one or more operations may be performed in parallel to fabricate integrated inductors with a conductive polymer separation layer substantially simultaneously. In another example, the operations may be performed in a different order to reflect the structure in which integrated inductors with conductive polymer separation layers will be implemented.

In addition, the example fabricating method of FIG. 7 may include other operations not specifically shown in FIG. 7, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 7 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive, and a slurry to remove the overburden and planarize the surface.

Turning to FIG. 7, the method 700 begins with a process 702 of forming an opening in a layer of glass (e.g., a glass substrate or glass core). The IC structure 800A of FIG. 8A is an example resulting structure of the process 702. The IC structure 800A depicts an opening 802 in the layer of glass 210. The opening 802 may be referred to as a TGV opening, a through hole, or a PTH (e.g., referring to electroplating in subsequent processes). The opening 802 extends between a first face 813-1 and a second face 813-2 of the layer of glass 210. Although a single opening 802 is shown in FIG. 8A, the microelectronic assemblies described herein may include any number of such openings. Multiple openings such as the opening 802 may be formed in the glass, some of which may be filled with a conductive material to form conductive vias, and some of which may be filled with materials as described herein to form embedded inductors with conductive polymer separation layers. The opening 802 may be formed in the layer of glass 210 using any suitable subtractive technique such as direct laser drilling or a laser-induced etching process, possibly in combination with any suitable patterning technique such as photolithographic or electron-beam (e-beam) patterning. In other embodiments, the opening 802 may be formed during fabrication of the layer of glass 210 itself, e.g., when molten glass is filled into a mold that has space for the future opening. Although FIG. 8A and subsequent drawings depict the opening 802 as having a substantially straight profile, the opening 802 may have a cross-sectional shape that tapers from one or both sides. In an example in which the opening 802 tapers from both sides, the opening 802 may have widths at both ends (e.g., a first width in plane with the face 813-1 and a second width in a plane with the face 813-2) that are greater than a width between the two ends (e.g., a third width between the first and second widths may be smaller than the first and second widths). In the example illustrated in FIG. 8A, an insulator material 212 is provided on sidewalls 803 of the opening 802, as well as over faces 813-1 and 813-2. In one such example, the insulator material 212 may act as a buffer layer between the glass 210 and subsequently deposited materials; however, in other examples, a buffer layer may not be deposited on sidewalls 803 of the opening 802.

Referring again to the method 700 of FIG. 7, the method 700 continues with a process 704 of providing a conductive material as a seed layer on sidewalls of the opening. The IC structure 800B of FIG. 8B is an example resulting IC structure of the process 704. The IC structure 800B includes a layer of conductive material 826 on the sidewalls 803 of the opening. In the example illustrated in FIG. 8B, the conductive material 826 is deposited on the insulator material 212 on the sidewalls 803 of the opening 802. The conductive material 826 may be deposited with any suitable technique, such as a physical vapor deposition process (e.g., sputter), and may be any suitable seed material, such as copper or another suitable conductive seed material.

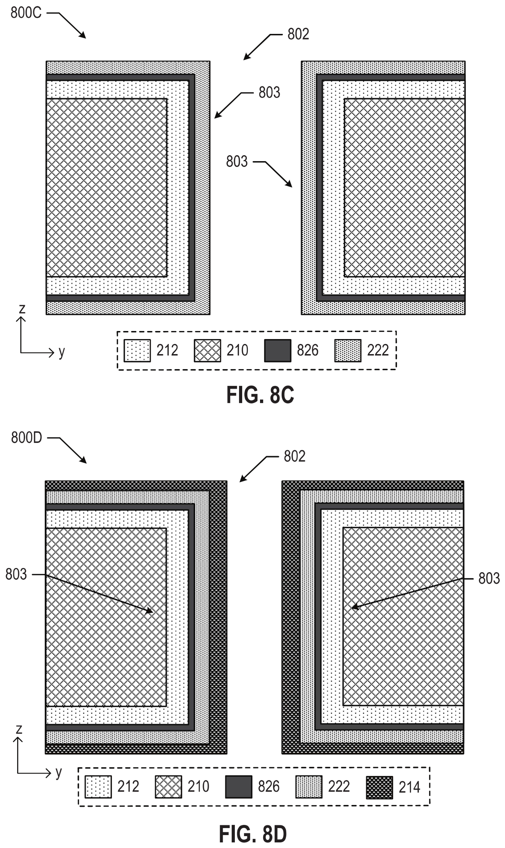

Referring again to the method 700 of FIG. 7, the method 700 continues with a process 706 of providing a conductive polymer over the conductive material on the sidewalls. The IC structure 800C of FIG. 8C is an example resulting IC structure of the process 706. The IC structure 800C includes a layer of the conductive polymer 222 over the conductive material 826 of the seed layer on the sidewalls 803 of the opening 802. The conductive polymer 222 may include one or more conductive polymer materials, such as polythiophene and polypyrrole, and/or another suitable polymer material, and may be deposited using any suitable deposition technique. According to examples, the thickness (e.g., width) of the conductive polymer 222 deposited on the sidewalls 803 may depend on the dopant concentration to achieve the desired conductivity. In some examples, the thickness of the conductive polymer 222 deposited on the sidewalls may be in a range of about 1-10 micrometers, or about 2-6 micrometers.

Referring again to the method 700 of FIG. 7, the method 700 continues with a process 708 of providing a magnetic material over the conductive polymer on the sidewalls. The IC structure 800D of FIG. 8D is an example resulting IC structure of the process 708. As can be seen in FIG. 8D, the IC structure 800D includes a layer of the magnetic material 214 on sidewalls 803 of the opening over the conductive polymer 222. The magnetic material 214 may be provided with an electroplating process directly on the conductive polymer 222. In some examples, the thickness (e.g., width) of the magnetic material deposited on the sidewalls 803 is in a range of about 1-5 micrometers. As mentioned above with respect to FIGS. 5A-5B, in some examples, multiple alternating layers of the conductive polymer 222 and the magnetic material 214 may be deposited on the sidewalls.

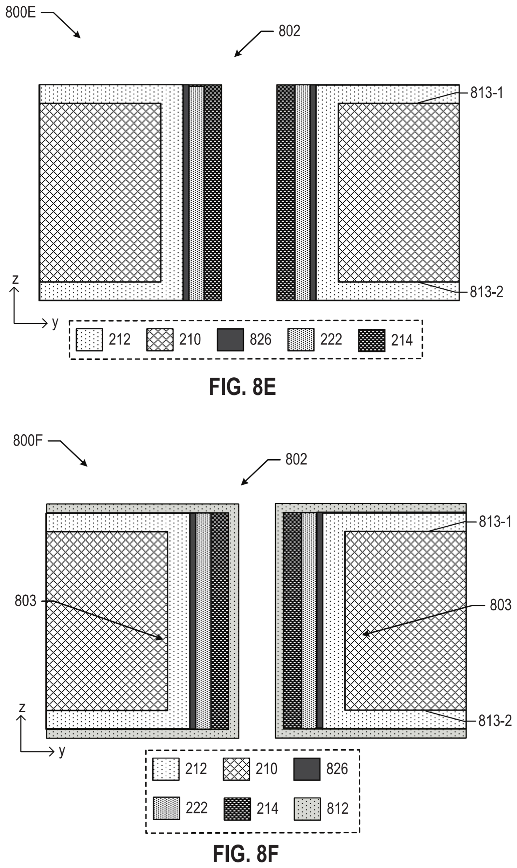

The method may then involve one or more polishing and/or etch processes to remove the magnetic material 214, conductive polymer 222, and conductive material 826 from the top and bottom sides (e.g., from the first face 813-1 and the second face 813-2). The IC structure 800E of FIG. 8E is an example resulting IC structure of the processes of removing the magnetic material 214 and conductive materials from the top and bottom sides of the structure. As can be seen in FIG. 8E, the insulator material 212 is exposed at the top side and bottom side of the structure after polishing. In another example in which the insulator material 212 is not present over the first face 813-1 and over the second face 813-2, the glass 210 may be exposed at the face 813-1 and 813-2 after such polish/etch processes. For example, FIGS. 6A and 6B illustrate an example IC structure 600 in which the glass was exposed after polishing to remove materials from the faces of the glass.

Referring again to the method 700 of FIG. 7, the method 700 continues with a process 710 of providing an insulator material over the magnetic material on the sidewalls. The IC structure 800F of FIG. 8F is an example resulting IC structure of the process 710. The IC structure 800F includes a layer of the insulator material 812 on the sidewalls 803 over the magnetic material 214, as well as over the top and bottom sides (e.g., over the faces 813-1 and 813-2). The insulator material 812 may be any suitable insulator material, such as an insulating polymer material, or any other suitable insulator material, and may be deposited on the sidewalls 803 according to any suitable deposition process. The insulator material 812 may have a material composition that is the substantially the same as or different from the insulator material 212.

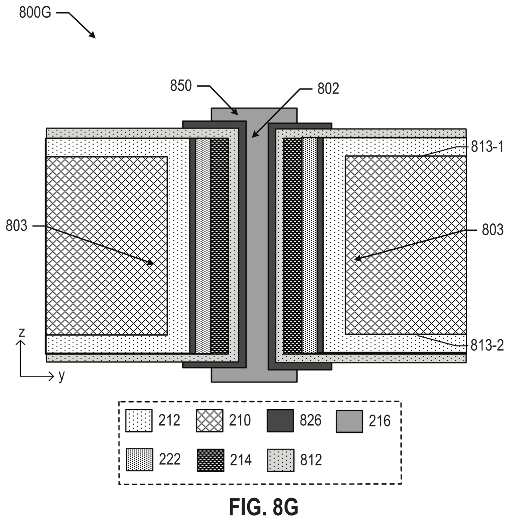

Referring again to the method 700 of FIG. 7, the method 700 continues with a process 712 of providing a conductive material in the opening. The IC structure 800G of FIG. 8G is an example resulting IC structure of the process 712. Providing a conductive material may involve filling the opening 802 with a conductive material 216. For example, the conductive material 216 may be deposited with an electroplating process. In one such example, the method involves depositing another conductive material 826 as a seed layer over the insulator material 812, and the electroplating the conductive material 216 on the conductive material 826. As can be seen in FIG. 8G, the IC structure 800G includes a continuous portion of the conductive material 216 in the opening 802 between the first face 813-1 and the second face 813-2. In other examples, the opening 802 may not be completely filled by the conductive material 216, or an opening in the conductive material 216 may be formed in order to provide a further material in the opening on the conductive material 216, such as shown in FIGS. 4A-4B.

Thus, FIG. 7 illustrates a method 700 for fabricating an IC structure or microelectronic assembly including an integrated inductor with a conductive polymer separation layer. Performing the method 700 may result in several features in the final IC structure that are characteristic of the use of the method 700. For example, one such feature is illustrated in the IC structure 800G of FIG. 8G, in which the layer of glass 210 (or other core or core material in a substrate) includes a via 850 through the core (e.g., through the layer of glass) and extending between the first face 813-1 and the second face 813-2, a conductive material 216 in the via, a seed layer (e.g., the conductive material 216) on sidewalls 803 of the via 850 between the core and the conductive material 216, where the seed layer includes a metal, a conductive polymer 222 on the sidewalls 803 between the seed layer and the conductive material 216, a magnetic material 214 on the sidewalls 803 between the conductive polymer 222 and the conductive material 216, and an insulator material812 on the sidewalls 803 between the magnetic material 214 and the conductive material 216. In another example, performing the method 700 may include performing processes 706 and 708 multiple times to deposit multiple alternating layers of a conductive polymer 222 and a magnetic material 214. One such example is shown in FIGS. 5A-5B, where the IC structure 500 includes two layers of the conductive polymer 222 and the magnetic material 214 on the sidewalls of the opening in which the inductor structure is disposed. Integrated inductors with conductive polymer layers in accordance with examples described herein may enable plating magnetic materials with a high density and uniformity, at a panel scale (e.g., at a scale of about 500 mm). Additionally, a conductive polymer layer in accordance with examples described herein may reduce the negative impact of eddy current on the performance of the inductor.

IC structures and microelectronic assemblies including integrated inductors with conductive polymer separation layers in accordance with techniques described herein may be included in any suitable electronic component or electronic device. FIGS. 9-12 illustrate various examples of apparatuses that may include one or more of the IC structures or assemblies with integrated inductors with conductive polymer separation layers disclosed herein.

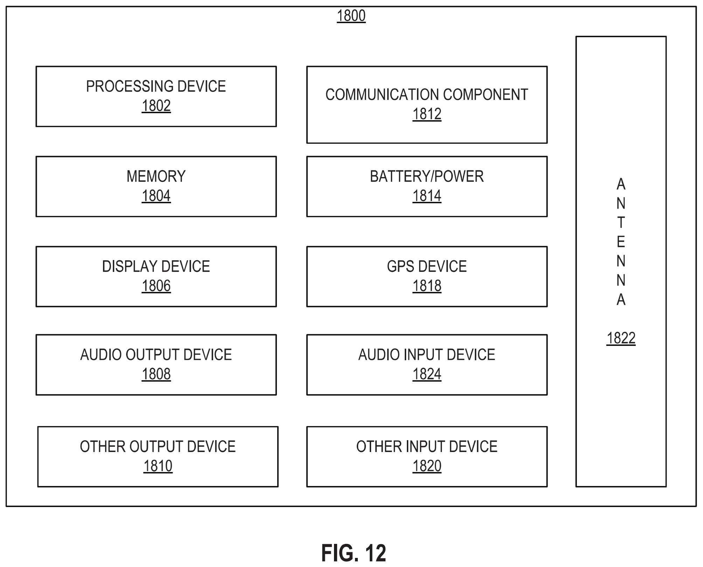

FIG. 9 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 12) or other logic that is configured to store information in the memory devices or execute instructions stored in the memory array.

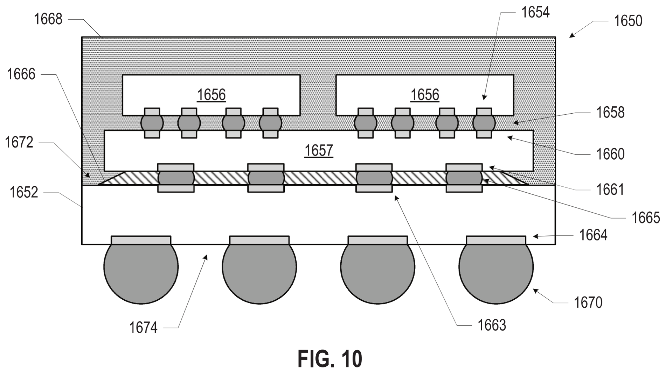

FIG. 10 is a side, cross-sectional view of an example IC package 1650 that may include an assembly or one or more IC structures with integrated inductors with polymer separation layers in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 10 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 10 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

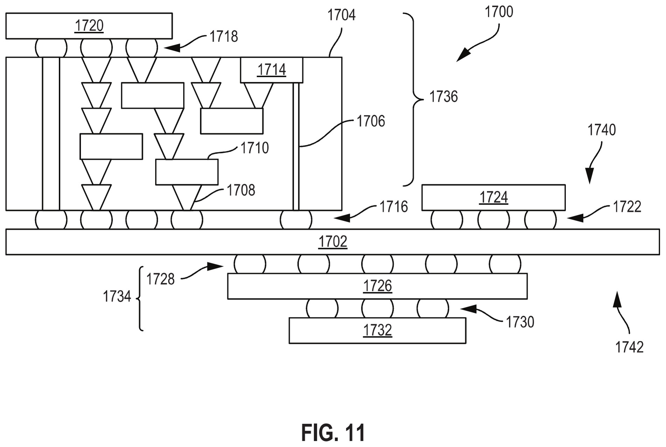

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 10 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 11.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 10 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 10, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 11 is a side, cross-sectional view of an IC device assembly 1700 that may include one or more IC packages or other electronic components (e.g., a die) including an assembly or one or more IC structures with integrated inductors with polymer separation layers in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 10 (e.g., may include one or more IC structures in accordance with embodiments described herein).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 11 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 11), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 11, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 9), an IC device, or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 11, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 11 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 12 is a block diagram of an example electrical device 1800 that may include an assembly or one or more IC structures with integrated inductors with polymer separation layers in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 12 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 12, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides a microelectronic assembly, including a layer of glass including a first face and a second face; and an inductor in the layer, where the inductor includes a continuous portion of a conductive material between the first face and the second face, a magnetic material at least partially surrounding the conductive material, and a conductive polymer at least partially surrounding the magnetic material.

Example 2 provides the microelectronic assembly of example 1, where: the conductive polymer includes one or more of: polythiophene and polypyrrole.

Example 3 provides the microelectronic assembly of example 2, where: the conductive polymer further includes an alkali metal or DMBI-H.

Example 4 provides the microelectronic assembly of any one of examples 1-3, where: the conductive polymer has a conductivity in a range of about 100-1000 S/m.

Example 5 provides the microelectronic assembly of any one of examples 1-4, where: the conductive polymer has a thickness in a range of about 1 to 10 microns, where the thickness is a dimension of the conductive polymer in a plane substantially parallel with the layer.

Example 6 provides the microelectronic assembly of any one of examples 1-5, where: the magnetic material includes one or more of iron, cobalt, and nickel.

Example 7 provides the microelectronic assembly of example 6, where: the magnetic material further includes one or more of: boron, sulfur, phosphorus, and oxygen.

Example 8 provides the microelectronic assembly of any one of examples 1-7, where: the conductive polymer is a first conductive polymer layer and the magnetic material is a first magnetic material layer, and the inductor further includes a second magnetic material layer at least partially surrounding the first conductive polymer layer, and a second conductive polymer layer at least partially surrounding the second magnetic material layer.

Example 9 provides the microelectronic assembly of any one of examples 1-8, where: the inductor includes an insulator material between conductive material and the magnetic material.

Example 10 provides the microelectronic assembly of example 9, where: the inductor includes a seed layer between the insulator material and the conductive material, where the seed layer includes a metal.

Example 11 provides the microelectronic assembly of example 10, where the seed layer is a first seed layer, and where the microelectronic assembly further includes a second seed layer between the glass and the conductive polymer.

Example 12 provides the microelectronic assembly of any one of examples 1-11, further including an insulator material between the glass and the conductive polymer.

Example 13 provides the microelectronic assembly of any one of examples 1-12, where: the inductor includes an insulator material, and the conductive material surrounds the insulator material.

Example 14 provides a microelectronic assembly, including a substrate including a core, where the core includes a first face and a second face opposite the first face; a via through the core and extending between the first face and the second face; a conductive material in the via; a seed layer on sidewalls of the via between the core and the conductive material, where the seed layer includes a metal; a conductive polymer material on the sidewalls between the seed layer and the conductive material; a magnetic material on the sidewalls between the conductive polymer and the conductive material; and an insulator material on the sidewalls between the magnetic material and the conductive material.

Example 15 provides the microelectronic assembly of example 14, where: the conductive polymer material includes a conjugated polymer material including one or more of an inorganic dopant and an organic molecular dopant.

Example 16 provides the microelectronic assembly of any one of examples 14-16, where the conductive polymer material is a first conductive polymer layer and the magnetic material is a first magnetic layer, and where the microelectronic assembly further includes a second conductive polymer layer including the conductive polymer material between the first magnetic layer and the insulator material, and a second magnetic layer including the magnetic material between the second conductive polymer layer and the insulator material.

Example 17 provides the microelectronic assembly according to any one of examples 1-16, where the microelectronic assembly includes or is a part of a central processing unit.

Example 18 provides the microelectronic assembly according to any one of examples 1-17, where the microelectronic assembly includes or is a part of a memory device.

Example 19 provides the microelectronic assembly according to any one of examples 1-18, where the microelectronic assembly includes or is a part of a logic circuit.

Example 20 provides the microelectronic assembly according to any one of examples 1-19, where the microelectronic assembly includes or is a part of input/output circuitry.

Example 21 provides the microelectronic assembly according to any one of examples 1-20, where the microelectronic assembly includes or is a part of a field programmable gate array transceiver.

Example 22 provides the microelectronic assembly according to any one of examples 1-21, where the microelectronic assembly includes or is a part of a field programmable gate array logic.

Example 23 provides the microelectronic assembly according to any one of examples 1-22, where the microelectronic assembly includes or is a part of a power delivery circuitry.

Example 24 provides an IC package that includes a microelectronic assembly according to any one of examples 1-23.

Example 25 provides the IC package according to example 24, further including a further IC component coupled to the microelectronic assembly.

Example 26 provides the IC package according to example 25, where the further IC component includes a package substrate.

Example 27 provides the IC package according to example 25, where the further IC component includes an interposer.

Example 28 provides the IC package according to example 25, where the further IC component includes a further assembly or die.

Example 29 provides a computing device that includes a carrier substrate and an assembly coupled to the carrier substrate, where the assembly is an assembly according to any one of examples 1-16 or the assembly is included in the IC package according to any one of examples 17-28.

Example 30 provides the computing device according to example 29, where the computing device is a wearable or handheld computing device.

Example 31 provides the computing device according to examples 29 or 30, where the computing device further includes one or more communication chips.

Example 32 provides the computing device according to any one of examples 29-31, where the computing device further includes an antenna.

Example 33 provides the computing device according to any one of examples 29-32, where the carrier substrate is a motherboard.

Example 34 provides an IC structure including an inductor in an opening in a layer of material (e.g., substrate core material such as glass or another substrate core), where the inductor includes a continuous portion of conductive material in the opening, a magnetic material around the conductive material, and a conductive polymer layer around the magnetic material.

Example 35 provides a method of fabricating a microelectronic assembly, the method including forming an opening in a core material (e.g., such as a layer of glass); providing a first conductive material on sidewalls of the opening, where the first conductive material includes a metal; providing a conductive polymer on the first conductive material; providing a magnetic material on the conductive polymer; providing an insulator material on the magnetic material; and filling the opening with a second conductive material over the insulator material.

Example 36 provides the method of example 35, where: providing conductive polymer includes electroplating the conductive polymer on the first conductive material.

Example 37 provides the method of any one of examples 35-36, where: providing the magnetic material includes electroplating the magnetic material on the conductive polymer.

Example 38 provides the method of any one of examples 35-37, where the insulator material is a first insulator material, and where the method further includes prior to providing the first conductive material, depositing a second insulator material on sidewalls of the opening.

Example 39 provides the method of any one of examples 35-38, where the conductive further including providing a further layer of the conductive polymer on the magnetic material; and providing a further layer of the magnetic material on the further layer of the conductive polymer.

Example 40 provides the method of any one of examples 35-39, where the opening is a first opening, and where the method further includes forming a second opening in the layer of glass; and filling the second opening with a conductive material.

Example 41 provides the method according to any one of examples 35-40, where the microelectronic assembly is a microelectronic assembly according to any one of the preceding examples.

Example 42 provides a process of making a microelectronic assembly according to the method of any one of examples 35-40.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

The following section of the description relates to further examples. The numbered paragraphs in this section are not claims. The claims are set forth below in the later section headed "claims".

### Clauses

Clause 1. A microelectronic assembly, comprising:
   a layer of glass comprising a first face and a second face; and
   an inductor in the layer, wherein the inductor comprises:
      a continuous portion of a conductive material between the first face and the second face,
      a magnetic material at least partially surrounding the conductive material, and a conductive polymer at least partially surrounding the magnetic material.
Clause 2. The microelectronic assembly of clause 1, wherein:
   the conductive polymer comprises one or more of: polythiophene and polypyrrole.
Clause 3. The microelectronic assembly of clause 2, wherein:
   the conductive polymer further comprises an alkali metal or DMBI-H.
Clause 4. The microelectronic assembly of clause 1, wherein:
   the conductive polymer has a conductivity in a range of about 100 to 1000 S/m.
Clause 5. The microelectronic assembly of clause 1, wherein:
   the conductive polymer has a thickness in a range of about 1 to 10 microns, wherein the thickness is a dimension of the conductive polymer in a plane substantially parallel with the layer.
Clause 6. The microelectronic assembly of clause 1, wherein:
   the magnetic material comprises one or more of iron, cobalt, and nickel.
Clause 7. The microelectronic assembly of clause 6, wherein:
   the magnetic material further comprises one or more of: boron, sulfur, phosphorus, and oxygen.
Clause 8. The microelectronic assembly of clause 1, wherein:
   the conductive polymer is a first conductive polymer layer and the magnetic material is a first magnetic material layer, and the inductor further comprises:
   a second magnetic material layer at least partially surrounding the first conductive polymer layer, and
   a second conductive polymer layer at least partially surrounding the second magnetic material layer.
Clause 9. The microelectronic assembly of clause 1, wherein:
   the inductor comprises an insulator material between conductive material and the magnetic material.
Clause 10. The microelectronic assembly of clause 9, wherein:
   the inductor comprises a seed layer between the insulator material and the conductive material, wherein the seed layer comprises a metal.
Clause 11. The microelectronic assembly of clause 10, wherein the seed layer is a first seed layer, and wherein the microelectronic assembly further comprises:
   a second seed layer between the glass and the conductive polymer.
Clause 12. The microelectronic assembly of clause 1, further comprising:
   an insulator material between the glass and the conductive polymer.
Clause 13. The microelectronic assembly of clause 1, wherein:
   the inductor comprises an insulator material, and the conductive material surrounds the insulator material.
Clause 14. A microelectronic assembly, comprising:
   a substrate comprising a core, wherein the core comprises a first face and a second face opposite the first face;
   a via through the core and extending between the first face and the second face;
   a conductive material in the via;
   a seed layer on sidewalls of the via between the core and the conductive material, wherein the seed layer comprises a metal;
   a conductive polymer material on the sidewalls between the seed layer and the conductive material;
   a magnetic material on the sidewalls between the conductive polymer material and the conductive material; and
   an insulator material on the sidewalls between the magnetic material and the conductive material.
Clause 15. The microelectronic assembly of clause 14, wherein:
   the conductive polymer material comprises a conjugated polymer material comprising one or more of an inorganic dopant and an organic molecular dopant.
Clause 16. The microelectronic assembly of clause 14, wherein the conductive polymer material is a first conductive polymer layer, and the magnetic material is a first magnetic layer, and wherein the microelectronic assembly further comprises:
   a second conductive polymer layer comprising the conductive polymer material between the first magnetic layer and the insulator material, and
   a second magnetic layer comprising the magnetic material between the second conductive polymer layer and the insulator material.
Clause 17. A method of fabricating a microelectronic assembly, the method comprising:
   forming an opening in a core material;
   providing a first conductive material on sidewalls of the opening, wherein the first conductive material comprises a metal;
   providing a conductive polymer on the first conductive material;
   providing a magnetic material on the conductive polymer;
   providing an insulator material on the magnetic material; and
   filling the opening with a second conductive material over the insulator material.
Clause 18. The method of clause 17, wherein:
   providing the conductive polymer comprises electroplating the conductive polymer on the first conductive material.
Clause 19. The method of clause 17, wherein:
   providing the magnetic material comprises electroplating the magnetic material on the conductive polymer.
Clause 20. The method of clause 17, wherein the insulator material is a first insulator material, and wherein the method further comprises:
   prior to providing the first conductive material, depositing a second insulator material on sidewalls of the opening.

## Claims

1. A microelectronic assembly, comprising:
a layer of glass comprising a first face and a second face; and
an inductor in the layer, wherein the inductor comprises:
a continuous portion of a conductive material between the first face and the second face,
a magnetic material at least partially surrounding the conductive material, and
a conductive polymer at least partially surrounding the magnetic material.

2. The microelectronic assembly of claim 1, wherein:
the conductive polymer comprises one or more of: polythiophene and polypyrrole.

3. The microelectronic assembly of claim 2, wherein:
the conductive polymer further comprises an alkali metal or DMBI-H.

4. The microelectronic assembly of any one of claims 1-3, wherein:
the conductive polymer has a conductivity in a range of about 100 to 1000 S/m.

5. The microelectronic assembly of any one of claims 1-4, wherein:
the conductive polymer has a thickness in a range of about 1 to 10 microns, wherein the thickness is a dimension of the conductive polymer in a plane substantially parallel with the layer.

6. The microelectronic assembly of any one of claims 1-5, wherein:
the magnetic material comprises one or more of iron, cobalt, and nickel.

7. The microelectronic assembly of claim 6, wherein:
the magnetic material further comprises one or more of: boron, sulfur, phosphorus, and oxygen.

8. The microelectronic assembly of any one of claims 1-7, wherein:
the conductive polymer is a first conductive polymer layer and the magnetic material is a first magnetic material layer, and the inductor further comprises:
a second magnetic material layer at least partially surrounding the first conductive polymer layer, and
a second conductive polymer layer at least partially surrounding the second magnetic material layer.

9. The microelectronic assembly of any one of claims 1-8, wherein:
the inductor comprises an insulator material between conductive material and the magnetic material.

10. The microelectronic assembly of claim 9, wherein:
the inductor comprises a seed layer between the insulator material and the conductive material, wherein the seed layer comprises a metal.

11. The microelectronic assembly of claim 10, wherein the seed layer is a first seed layer, and wherein the microelectronic assembly further comprises:
a second seed layer between the glass and the conductive polymer.

12. The microelectronic assembly of any one of claims 1-11, further comprising:
an insulator material between the glass and the conductive polymer.

13. The microelectronic assembly of any one of claims 1-12, wherein:
the inductor comprises an insulator material, and the conductive material surrounds the insulator material.

14. A method of fabricating a microelectronic assembly, the method comprising:
forming an opening in a core material;
providing a first conductive material on sidewalls of the opening, wherein the first conductive material comprises a metal;
providing a conductive polymer on the first conductive material;
providing a magnetic material on the conductive polymer;
providing an insulator material on the magnetic material; and
filling the opening with a second conductive material over the insulator material.

15. The method of claim 14, wherein:
providing the conductive polymer comprises electroplating the conductive polymer on the first conductive material.
